Europäisches Patentamt

European Patent Office

Office européen des brevets

(11) Veröffentlichungsnummer : **0 133 204**
**B1**

(12) **EUROPÄISCHE PATENTSCHRIFT**

(45) Veröffentlichungstag der Patentschrift :
09.09.87

(51) Int. Cl.⁴ : **H 01 L 21/225**, H 01 L 21/318, H 01 L 29/78

(21) Anmeldenummer : 84106690.5

(22) Anmeldetag : 12.06.84

(54) Verfahren zum Herstellen eines DMOS-Transistors.

(30) Priorität : 27.06.83 BE 260137

(43) Veröffentlichungstag der Anmeldung :
20.02.85 Patentblatt 85/08

(45) Bekanntmachung des Hinweises auf die Patenterteilung : 09.09.87 Patentblatt 87/37

(84) Benannte Vertragsstaaten :
AT DE FR GB IT NL SE

(56) Entgegenhaltungen :
US-A- 3 895 390
US-A- 3 909 320
US-A- 3 919 008
IEEE JOURNAL OF SOLID-STATE CIRCUITS, Band SC-11, Nr. 6, Dezember 1976, New York, USA; J.D. PLUMMER "A monolithic 200-V CMOS analog switch", Seiten 809-817

(73) Patentinhaber : Alcatel N.V.
De Lairessestraat 153
NL-1075 HK Amsterdam (NL)

(72) Erfinder : Schols, Gustaaf
De Meersen 19
B-8200 Brugge 2 (BE)

(74) Vertreter : Graf, Georg Hugo, Dipl.-Ing. et al
c/o Standard Elektrik Lorenz AG Patent- und Lizenzwesen Postfach 30 09 29 Kurze Strasse 8
D-7000 Stuttgart 30 (DE)

## Beschreibung

Die Erfindung betrifft ein Verfahren zum Herstellen eines Halbleiterbauelements, welches Verfahren zumindest einen ersten Verfahrensschritt mit einem Aufbringungsprozess von Dotierungsmaterial des einen Leitungstyps auf ein Substrat des anderen Leitungstyps und einen ersten Eintreibungsprozess des Dotierungsmaterials zur Bildung einer im Substrat angeordneten Wanne des einen Leitungstyps enthält, und einen zweiten Verfahrenschritt mit einem zweiten Aufbringungsprozess von Dotierungsmaterial und einen zweiten Eintreibungsprozess zur Ausbildung eines von dem Wannenrand über eine Kanalzone beabstandeten Bereichs aufweist.

Ein derartiges Verfahren ist bereits aus dem Aufsatz, « A Monolithic 200V CMOS Analog Switch » von J.D. Plummer und J.D. Meindl bekannt, der in der Zeitschrift « IEEE Journal of Solid-State Circuits » Band SC-11, Nr.6 (Dezember 1976) Seiten 809-817, veröffentlicht wurde. Er wird zur Herstellung eines Hochspannungs-N-Kanal-DMOS-Transistors angewendet, wobei die Wanne und die Zone durch die gleiche Öffnung in einer Oxidschicht ausgebildet wird, welche das Substrat bedeckt. Die Wanne, die Zone und das Substrat werden aus $P^-$-, $N^+$- bzw. $N^-$-Material hergestellt. In diesem Artikel wird erwähnt, daß die Kanalzone zwischen der $N^+$-Zone und dem $N^-$-Substrat, die als Quelle und Senke des DMOS-Transistors verwendet werden, zumindest eine Länge von 2,5 µm zur Verhinderung eines Durchgriffsabbruchs zwischen der Senke und der Quelle aufweisen sollte.

Es wurde gefunden, daß ein derartiger Durchgriffsabbruch relativ häufig auftritt. Aufgabe der Erfindung ist daher die Angabe eines Verfahrens der oben genannten Art, bei dem die Gefahr der Erzeugung solcher Leckstrompfade zumindest beträchtlich vermindert ist.

Diese Aufgabe wird erfindungsgemäß dadurch gelöst, daß die Kanalzone unter einer aus einer polykristallinen Siliziumschicht und einer Gateoxidschicht bestehenden Gateelektrode gebildet wird, die zumindest während des ersten Eintreibungsprozesses mit einer Siliziumnitridschicht bedeckt ist.

Die eine sehr dichte Struktur aufweisende Siliziumnitridschicht schützt die aus polysilizium bestehende Gateelektrode gegen möglicherweise unerwünschte Effekte beim ersten Eintreibungsprozess bei einer relativ hohen Temperatur, Beispielsweise 1 200 °C, über eine lange Zeitdauer, beispielsweise 50 Stunden, und in einer nichtoxidierenden Atmosphäre, wie Stickstoff. Es wurde gefunden, daß bei einer solchen Verfahrensweise keine Narbung der aus Polysilizium bestehenden Gateelektrode während des ersten Diffusions-Eintreibungsgprozesses auftritt. Demzufolge kann das während des zweiten Aufbringungsprozesses eingebrachte Verunreinigungsmaterial nicht die Zone unter der aus polykristallinem Silizium bestehenden Gateelektrode erreichen und daher nicht die so erzielte Kanallänge beeinträchtigen.

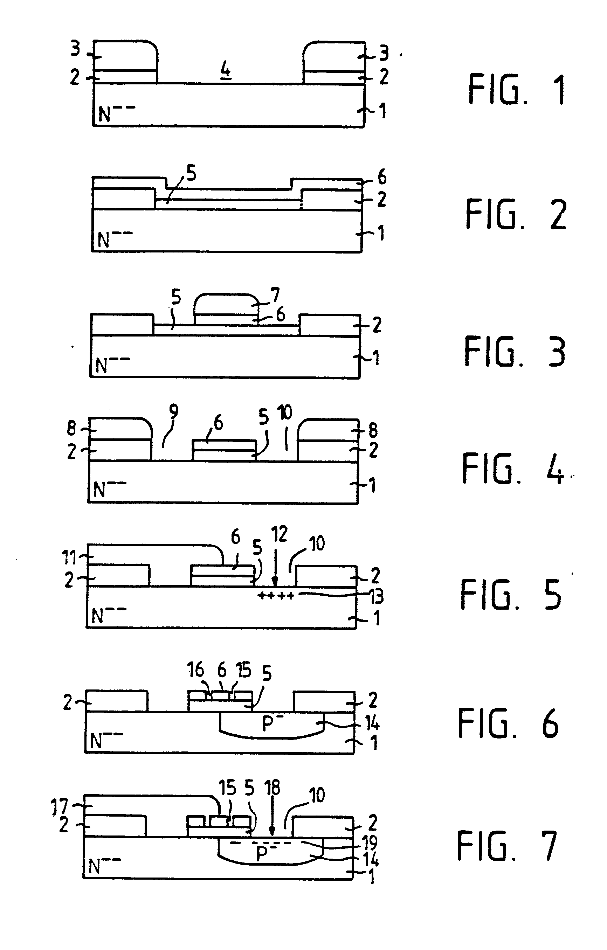

Die Merkmale der Erfindung, ihre Vorteile und Weiterbildungen werden im Folgenden an einem Ausführungsbeispiel an Hand der Zeichnung verdeutlicht, deren Figuren 1 bis 10 zur Veranschaulichung von aufeinanderfolgenden Verfahrensschritten zur Herstellung eines Halbleiterbauelements dienen, wobei die Bestandteile nicht maßstabsgerecht dargestellt sind, und deren Figuren 11 bis 13 zur Erläuterung von aufeinanderfoldenden Verfahrensschritten eines Verfahrens nach der Erfindung zur Herstellung eines Halbleiterbauelements dienen, wobei wiederum die Bauelementbestandteile nicht maßstabsgerecht gezeichnet sind.

Die Figuren 1 bis 8 zeigen acht aufeinanderfolgende Hauptverfahrensprozesse zum Herstellen eines DMOS-Transistors, d. h. eines doppelt diffundierten MOS-Transistors.

Gemäß der Figur 1 wird von einem $N^-$-Substrat 1 ausgegangen, d. h. von einem sehr leicht n dotiertem Substrat, und darauf eine sogenannte Feld-siliziumoxidschicht 2 aufgewachsen. Dann wird auf dem sogenannten aktiven Bereich der Schicht 2 die Maskierung 3 ausgebildet, um diesen Bereich während eines anschließend erfolgenden Ätzprozesses zu schützen, bei dem die ungeschützten Teile der Schicht 2 entfernt werden. Somit werden in dieser Schicht 2 Fenster 4 erzeugt.

Nach der Figur 2 wird auf der oberen Oberfläche des Bauelements zunächst die Gate-siliziumoxidschicht 5 aufgewachsen und dann die polykristalline Siliziumschicht 6 über die Siliziumoxidschicht 5 abgeschieden.

Gemäß der Figur 3 wird eine Maske 7 auf dem sogenannten Gatebereich der polykristallinen Siliziumschicht 6 aufgebracht, um diesen Gatebereich während eines anschließenden Ätzprozesses zu schützen, der zur Entfernung der ungeschützten anderen Bereiche dient.

Gemäß der Figur 4 wird wieder auf dem aktiven Bereich der Schicht 2 eine Photolackmaske 8 zum Schutz dieses Bereiches während eines anschließend erfolgenden Ätzprozesses ausgebildet, wobei die Bereiche der Siliziumoxidschicht 5, welche nicht mittels der polykristallinen Siliziumschicht 6 geschützt sind, entfernt werden. Auf diese Weise wird der von der polykristallinen Siliziumschicht 6 bedeckte Bereich der das Gateoxid bildenden Siliziumoxidschicht 5, welches zwei Fenster 9 und 10 in der Feldoxidschicht 2 trennt, ausgebildet.

Wie die Figur 5 veranschaulicht, wird eine sogenannte $P^-$-Maskierung 11 auf dem linken Teil der Schicht 2, auf dem Substrat 1 innerhalb des Fensters 9 und auf einem Teil der polykristallinen Si-Schicht 6 gebildet, hauptsächlich, um dieses Substrat 1 während des anschließend erfolgenden Aufbringungsprozesses von P-dotierendem Material, beispielsweise von Bor, in das Substrat 1 durch das Fenster 10 zu schützen. Der Abscheidungsprozess wird mittels Ionenimplantation durchgeführt, was schematisch durch den Pfeil 12 angedeutet wird, und ergibt eine dünne Dotierungsschicht 13 mit p-dotierendem Material unter der oberen Oberflächenseite des Substrats 1 innerhalb des Fensters 10. Diese Dotierungsschicht 13, die durch Pluszeichen angedeutet ist, da sie positive P-Ionen bewirkt, ist schwach dotiert. Bemerkenswert ist, daß während dieses Implantationsprozesses sowohl die polykristalline Siliziumschicht 6 als auch die ungeschützte Schicht 2 als Maskierung wirksam sind, um sicherzustellen, daß nur innerhalb des Fensters 10 P-Dotierendes Material in die Substratoberfläche implantiert wird. Dies ist der Grund, weshalb die P⁻-Maskierung 11 sich in seitlicher Richtung nicht über die polykristalline Siliziumschicht 6 hinaus erstrecken sollte.

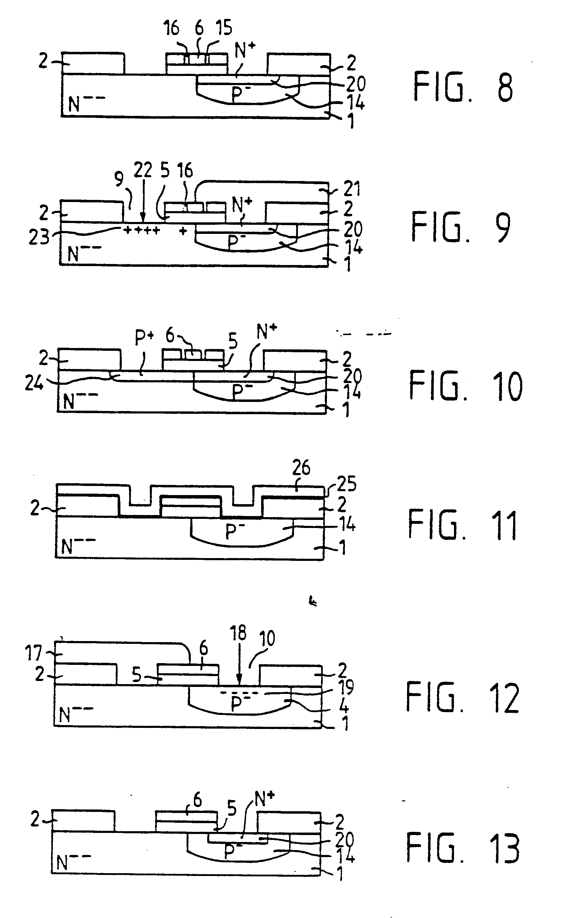

Die Figur 6 veranschaulicht, wie die Dotierungsschicht 13 während eines Eintreibungsprozesses bei einer relativ hohen Temperatur, beispielsweise 1 200 °C, und während eines langen Zeitraumes von beispielsweise 50 Stunden in einer nicht-oxidierenden Atmosphäre, beispielsweise Stickstoff, diffundiert. Im Ergebnis wird die leicht dotierte sogenannte P⁻-Wanne 14 erhalten, die sich seitlich unter die Gateoxidschicht 5 und unter die Feldoxidschicht 2 erstreckt.

Es wurde festgestellt, daß nach dem Abschluß der Diffusion des Eintreibungsprozesses in der polykristallinen Siliziumschicht 6 Narben, beispielsweise 15 und 16, gebildet wurden, welche sich durch diese Schicht erstrecken und das Material der darunter liegenden Gateoxidschicht 5 errreichen.

Gemäß der Figur 7 wird auf dem linken Teil der Schicht 2 dem Substrat innerhalb des Fensters 9 und einem Teil der polykristallinen Siliziumschicht 6 eine sogenannte N⁺-Maskierung 17 gebildet, hauptsächlich zum Schutz dieses Substrats 1 während eines anschließend erfolgenden Aufbringungsprozesses von n-dotierendem Material, beispielsweise Phosphor, in das Substrat 1 durch das Fenster 10. Dieser Aufbringungsprozess erfolgt mittels Ionenimplantation, wie es schematisch durch den Pfeil 18 angedeutet wird, und ergibt die Dotierungsschicht 19 unterhalb der oberen Oberflächenseite des Substrats 1. Aufgrund des Vorhandenseins der Narbe 15 und der Tatsache, daß die polykristalline Siliziumschicht 6 kein Hindernis für die negativen N-Ionen darstellt, erstreckt sich diese Dotierungsschicht 19 nicht nur über die Substratoberfläche innerhalb des Fensters 10, sondern auch noch unter die Gateoxidschicht 5. Diese Dotierungsschicht 19, welche durch Minuszeichen angezeigt ist, da sie negative N-Ionen erzeugt, ist stark dotiert.

Es ist zu bemerken, daß während dieses Implantationsprozesses sowohl die polykristalline Siliziumschicht 6 als auch die ungeschützte Schicht 2 als Maskierung verwendet werden, um sicherzustellen, daß mit Ausnahme der Narben n-dotierendes Material lediglich innerhalb des Fensters 10 in die Substratoberfläche implantiert wird. Somit gewährleistet die polykristalline Siliziumschicht 6, daß die Dotierungsschichten 13 und 19 in sogenannter selbst ausgerichteter Weise implantiert werden, womit gemeint ist, daß diese Dotierungsschichten genau im selben Fenster 10 gebildet werden.

Die Figur 8 veranschaulicht, wie die Dotierungsschicht 19 durch Diffusion in die P⁻-Wanne 14 während eines Eintreibungsprozesses in gleicher Weise wie bereits beschrieben eingetrieben wird. Als Ergebnis wird eine sogenannte N⁺- Zone 20 erhalten, die sich seitlich unter die Feldoxidschicht 2 und unter die Gateoxidschicht 5 erstreckt, wo sie den Rand der P⁻-Wanne 14 erreicht, wodurch die Länge der Kanalzone zwischen den Grenzen der Zone 20 und der Wanne 14 auf einen Nullwert vermindert wird. Da diese Zone 20 und das Substrat 1 als Quelle bzw. Senke des DMOS-Transistors verwendet werden müssen, wir dieser offensichtlich funktionsunfähig sein.

Wollte man auch einen PMOS-Transistor verwirklichen wollen, so könnte man, wie an Hand der Figuren 9 und 10 im Folgenden kurz beschrieben wird, folgendermaßen verfahren.

Während eines ersten zusätzlichen Hauptverfahrensschrittes bildet man gemäß der Figur 9 eine P⁺-Maskierung 21 auf dem Bauelement, um hauptsächlich das Fenster 10 zu schützen, wonach man p-dotierendes Material in das Fenster 9 implantiert, wie durch den Pfeil 22 angedeutet ist. Damit wird eine dünne Dotierungsschicht 23 von p-dotierendem Material unter der Oberfläche des Substrats gebildet, wie durch die Pluszeichen angezeigt wird. Aufgrund des Vorhandenseins der Narbe 16 wird jedoch diese Schicht 23 sich nicht lediglich unterhalb der oberen Oberflächenseite des Substrats 1 in dem Fenster 9 erstrecken, sondern ebenfalls unter die Gateoxidschicht 5.

Die Dotierungsschicht 23 wird gemäß der Figur 10 während eines zweiten zusätzlichen Hauptverfahrensschritt in das Substrat 1 eingetrieben und ergibt eine P⁺-Zone 24, die sich seitlich unter die Feldoxidschicht 2 und unter die Gateoxidschicht 5 erstreckt, wo sie den Rand der P⁻-Wanne 14 erreicht, womit die Länge der Kanalzonen zwischen den Rändern der Zone 24 und der Wanne 14 auf den Nullwert vermindert ist. Da diese Zone 24 und die Wanne 14 als Quelle und als Senke eines PMOS-Transistors verwendet werden sollen, ist letzterer offensichtlich funktionsunfähig.

Um das Entstehen des oben erwähnten Leckpfades, beispielsweise zwischen der N⁺-Zone 20 und dem N⁻-Substrat 1 zu verhindern, wird vor dem anhand der Figur 6 veranschaulichten P⁻-Eintreibungsprozess zunächst auf der oberen Oberflächenseite des Bauelements eine Siliziumoxidschicht 25 aufgewachsen und darauf dann eine Siliziumnitridschicht 26 abgeschieden, wie die Figur 11 zeigt. Es wurde festgestellt, daß auf diese Weise die polykristalline Siliziumschicht 6 gegen die unerwünschten Einflüsse bei der Diffusion des Eintreibungsprozesses geschützt ist, so daß keine Narbung dieser Schicht 6 entsteht. Im Ergebnis erstreckt sich nach Durchführung des siebten Arbeitsprozesses, was nunmehr die Figur 12 veranschaulicht, die Dotierungsschicht 19 nicht jenseits des Fensters 10, so daß während der Diffusion beim anschließenden Eintreibungsprozess, wie ihn die Figur 13 veranschaulicht, kein Leckpfad zwischen der $N^+$-Zone 20 und dem $N^-$-Substrat gebildet wird und deshalb auch nicht zwischen der Quellelektrode und der Senkenelektrode eines DMOS-Transistors, bei dem diese Zone und dieses Substrat als Quelle bzw. als Senke verwendet werden.

Das vorstehend erwähnte Verfahren nach der Erfindung wurde erfolgreich insbesondere bei der Herstellung von gesteuerten, in beiden Richtungen schaltbaren, Hochspannungsschaltern zur Ausführung gebracht, welche in beiden Richtungen 300 V sperren können und die vom Grundtyp sind, wie er in dem Aufsatz von W.H.A. Mattheus « 400 V Switches for Subscriber Line Interface » in der Zeitschrift « 1981, IEEE International Solid-State Circuits Conference. Digest of Papers », N.Y. USA, 18. bis 20. Februar 1981, Seiten 238 und 239, beschrieben ist.

## Patentansprüche

1. Verfahren zum Herstellen eines Halbleiterbauelements, welches Verfahren zumindest einen ersten Verfahrensschritt mit einem Aufbringungsprozess von Dotierungsmaterial des einen Leitungstyps auf ein Substrat des anderen Leitungstyps und einen ersten Eintreibungsprozess des Dotierungsmaterials zur Bildung einer im Substrat angeordneten Wanne des einen Leitungstyps enthält und einen zweiten Verfahrensschritt mit einem zweiten Aufbringungsprozess von Dotierungsmaterial und einem zweiten Eintreibungsprozess zur Ausbildung eines von dem Wannenrand über eine Kanalzone beabstandeten Bereichs aufweist, dadurch gekennzeichnet, daß die Kanalzone unter einer aus einer polykristallinen Siliziumschicht (6) und einer Gateoxidschicht (5) bestehenden Gateelektrode (5, 6) gebildet wird, die zumindest während des ersten Eintreibungsprozesses mit einer Siliziumnitridschicht (26) bedeckt ist.

2. Verfahren nach Anspruch 1, dadurch gekennzeichnet, daß die Kanalzone zwischen dem Rand einer Wanne (14), deren Dotierungsmaterial innerhalb einer Öffnung einer maskierenden Oberflächenschicht (2, 5 ; 6) in die freigelegte Oberfläche eines Substrats (1) während eines ersten Aufbringungsprozesses eingebracht wird, und einem Bereich (20) gebildet wird, dessen Dotierungsmaterial durch dieselbe Öffnung während eines zweiten Aufbringungsprozesses in die Oberfläche des Substrats (1) eingebracht wird.

3. Verfahren nach Anspruch 1, dadurch gekennzeichnet, daß die Kanalzone zwischen dem Rand einer Wanne (14), deren Dotierungsmaterial innerhalb einer ersten Öffnung (10) einer maskierenden Oberflächenschicht (2, 5 ; 6) in die freigelegte Oberfläche eines Substrats (1) während eines ersten Aufbringungsprozesses eingebracht wird, und einem Bereich (20) gebildet wird, dessen Dotierungsmaterial durch eine zweite Öffnung (9) während eines zweiten Aufbringungsprozesses in die Oberfläche des Substrats (1) eingebracht wird.

4. Verfahren nach Anspruch 2 oder 3, dadurch gekennzeichnet, daß das Dotierungsmaterial vor einem Eintreibungsprozess in die Oberfläche des Substrats (1, 2) während eines Ionenimplantationsprozesses aufgebracht wird.

5. Verfahren nach einem der Ansprüche 1 bis 4, dadurch gekennzeichnet, daß nach einem ersten Aufbringungsprozess ein erster Eintreibungsprozess unter Stickstoff erfolgt.

## Claims

1. Method of producing a semiconductor component, which method includes at least a first process stage with a process for the application of a doping material of the one conduction type on a substrate of the second conduction type and a first process for insertion of the doping material in order to form a recess of the first conduction type in the substrate and has a second process stage with a second process of application of doping material and a second insertion process for forming a region separated from the edge of the recess via a channel zone, characterized in that the channel zone is formed under a gate electrode (5, 6) consisting of a polycrystalline silicon layer (6) and a gate oxide layer (5), which gate electrode is covered, at least during the first insertion process, by a silicon nitride layer (26).

2. A method as claimed in Claim 1, characterized in that the channel zone is formed between the edge of a recess (14) whose doping material is introduced into the exposed surface of a substrate (1) within an aperture of a masking surface layer (2, 5 ; 6) during a first application process and an area (20) whose doping material is introduced into the surface of the substrate (1) through the same aperture during a second application process.

3. A method as claimed in Claim 1, characterized in that the channel zone is formed between the edge of a recess (14) whose doping material is introduced into the exposed surface of a substrate (1) within a first aperture (10) of a masking surface layer (2, 5 ; 6) during a first application process and an area (20) whose doping material is introduced into the surface of the substrate (1) through a second aperture (9) during a second application process.

4. A method as claimed in Claim 2 or 3, characterized in that the doping material is applied during an ion implantation process prior to an insertion process into the surface of the substrate (1, 2).

5. A method as claimed in any one of Claims 1 to 4, characterized in that, following a first application process, a first insertion process is carried out in nitrogen.

## Revendications

1. Procédé de fabrication d'un composant semi-conducteur, ce procédé incluant au moins une première étape de procédé incluant une opération de dépôt de matériau de dopage d'un premier type de conductibilité sur un substrat de l'autre type de conductibilité et une première opération de diffusion du matériau de dopage, afin de former un caisson du premier type de conductibilité dans le substrat et une deuxième étape de procédé comprenant une deuxième opération de dépôt de matériau de dopage et une deuxième opération de diffusion pour former une région séparée du bord du caisson par une zone de canal,
caractérisé en ce que,
la zone de canal est formée sous une électrode de grille (5, 6) constituée par une couche de silicium polycristallin (6) et une couche d'oxyde de grille (5, 6), laquelle, au moins durant la première opération de diffusion, est recouverte d'une couche de nitrure de silicium (26).

2. Procédé selon la revendication 1, caractérisé en ce que la zone de canal est formée entre le bord d'un caisson (14) dont le matériau de dopage est apporté, à travers une ouverture d'une couche de masquage (2, 5 ; 6), dans la surface découverte d'un substrat (1), au cours d'une première opération de dépôt, et une région (20) dont le matériau de dopage est apporté dans la surface du substrat, par la même ouverture durant une deuxième opération de dépôt.

3. Procédé selon la revendication 1, caractérisé en ce que la zone de canal est formée entre le bord d'un caisson (14) dont le matériau de dopage est apporté, à travers une ouverture d'une couche de masquage (2, 5 ; 6), dans la surface découverte d'un substrat (1), au cours d'une première opération de dépôt, et une région (20) dont le matériau de dopage est apporté dans la surface du substrat, par une deuxième ouverture (9) durant une deuxième opération de dépôt.

4. Procédé selon la revendication 2 ou 3, caractérisé en ce que le matériau de dopage est apporté dans la surface du substrat (1, 2) préalablement à une opération de diffusion, au cours d'une opération d'implantation ionique.

5. Procédé selon l'une quelconque des revendications 1 à 4, caractérisé en ce que, après une première opération de dépôt, il est procédé à une première opération de diffusion sous atmosphère d'azote.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13